Europäisches Patentamt

(19) European Patent Office

Office européen des brevets

(11) Numéro de publication: **0 042 641**
**B1**

(12) **FASCICULE DE BREVET EUROPEEN**

(45) Date de publication du fascicule du brevet:
29.08.84

(21) Numéro de dépôt: **81200636.9**

(22) Date de dépôt: **11.06.81**

(51) Int. Cl.³: **H 03 D 3/20**, H 04 L 27/14,
H 03 K 9/06

---

(54) **Démodulateur de fréquence utilisant un circuit à retard variable avec la fréquence reçue.**

---

(30) Priorité: **23.06.80 FR 8013866**

(43) Date de publication de la demande:
**30.12.81 Bulletin 81/52**

(45) Mention de la délivrance du brevet:
**29.08.84 Bulletin 84/35**

(84) Etats contractants désignés:
**DE FR GB IT NL SE**

(56) Documents cités:
**DE - A - 1 537 326
DE - B - 2 516 679
FR - A - 1 557 422
FR - A - 2 126 090
FR - A - 2 237 357
US - A - 3 739 288
US - A - 3 748 586**

(73) Titulaire: **TELECOMMUNICATIONS
RADIOELECTRIQUES ET TELEPHONIQUES T.R.T.,
88, rue Brillat Savarin, F-75013 Paris (FR)**

(72) Inventeur: **Boudault, Robert, SOCIETE CIVILE
S.P.I.D. 209, rue de l'Université, F-75007 Paris (FR)**
Inventeur: **Pouzoullic, Gérard, SOCIETE CIVILE
S.P.I.D. 209, rue de l'Université, F-75007 Paris (FR)**

(74) Mandataire: **Charpail, François et al, Société Civile
S.P.I.D. 209, rue de l'Université, F-75007 Paris (FR)**

BUNDESDRUCKEREI BERLIN

## Description

L'invention concerne un démodulateur de fréquence comprenant un circuit-porte ayant la fonction de »OU exclusif« et recevant sur ses deux entrées des signaux rectangulaires ayant la fréquence du signal modulé en fréquence, des moyens de retard pour retarder l'un desdits signaux rectangulaires par rapport à l'autre, enfin un filtre passe-bas connecté à la sortie du circuit-porte.

Un démodulateur de fréquence est utilisé par exemple pour restituer des données transmises par déplacement de la fréquence d'une porteuse.

Un démodulateur de fréquence du genre mentionné ci-dessus est décrit par exemple dans le brevet français n° 2 237 357. Dans les démodulateurs connus de ce type on utilise un circuit de retard pour produire un retard fixe de l'un des signaux rectangulaires appliqués à un circuit »OU exclusif«. Ce retard fixe est l'équivalent d'un déphasage du signal retardé proportionnel à la fréquence. A la sortie du circuit »OU exclusif«, on obtient un signal impulsionnel formé d'impulsions qui apparaissent aux instants des transitions du signal non retardé et qui ont une durée fixe. Le filtre passe-bas connecté à la sortie du circuit »OU exclusif« fournit la valeur moyenne de ce signal impulsionnel, valeur moyenne qui est proportionnelle au déphasage entre les signaux retardé et non retardé et donc proportionnelle à la fréquence du signal modulé. Le retard fixe peut être réalisé au moyen d'un registre à décalage suivant la technique utilisée dans le brevet précité n° 2 237 357 ou au moyen de circuits de retard analogiques quelconques.

Un tel démodulateur a une réponse en principe linéaire si le retard $\tau$ est indépendant de la fréquence F du signal modulé, ce qui n'est d'ailleurs pas toujours facile à réaliser avec des circuits de retard de type analogique. Mais, étant donné que sa réponse est forcément nulle pour F = 0 et maximale pour

$$F = \frac{1}{2\tau},$$

il a l'inconvénient de ne procurer qu'une variation relativement faible de son signal de sortie lorsque le domaine de fréquence $\Delta$ F du signal modulé est relativement étroit et éloigné de la fréquence F = 0.

Dans le brevet américain n° 3 748 586, il est décrit un démodulateur de fréquence du genre mentionné plus haut, mais dans lequel le retard d'un des signaux rectangulaires par rapport à l'autre est variable avec la fréquence F du signal modulé, de telle façon qu'en valeur absolue, la différence de phase entre lesdits signaux rectangulaires varie au maximum de 0 à 180° en sens inverse de leur fréquence. Ce retard variable est obtenu par un filtre électromécanique à deux pôles, en série avec un déphaseur de 90° et un circuit de mise en forme. Cette solution est assez compliquées et ne permet pas un réglage facile du retard pour adapter la réponse du démodulateur à l'excursion de fréquence du signal modulé en fréquence.

La présente invention a pour but de fournir un démodulateur du dernier type cité, mais avec des moyens de retard plus simples et aisément réglables.

Conformément à l'invention, dans ce démodulateur, lesdits moyens de retard comportent un circuit intégrateur recevant le signal non retardé, un circuit comparateur pour comparer à un signal de seuil le signal fourni par le circuit intégrateur, le signal retardé étant obtenu à partir de la sortie du circuit comparateur.

Lesdits moyens de retard variables avec la fréquence peuvent être réalisés de façon simple et relativement peu coûteuse au moyen de circuits analogiques. Deux modes de réalisation analogiques du démodulateur de fréquence de l'invention son fournis par la suite.

La description suivante en regard des dessins annexés, le tout donné à titre d'exemple, fera bien comprendre comment l'invention peut être réalisée.

La figure 1 est un schéma de principe du genre de démodulateur de fréquence utilisé dans l'invention.

La figure 2 représente des diagrammes de signaux apparaissant sur le schéma de la figure 1.

La figure 3 est un schéma d'un mode de réalisation du démodulateur de l'invention.

La figure 4 représente des diagrammes de signaux apparaissant sur le schéma de la figure 3.

La figure 5 est un schéma d'un autre mode de réalisation du démodulateur de l'invention.

La figure 6 représente des diagrammes de signaux apparaissant sur le schéma de la figure 5.

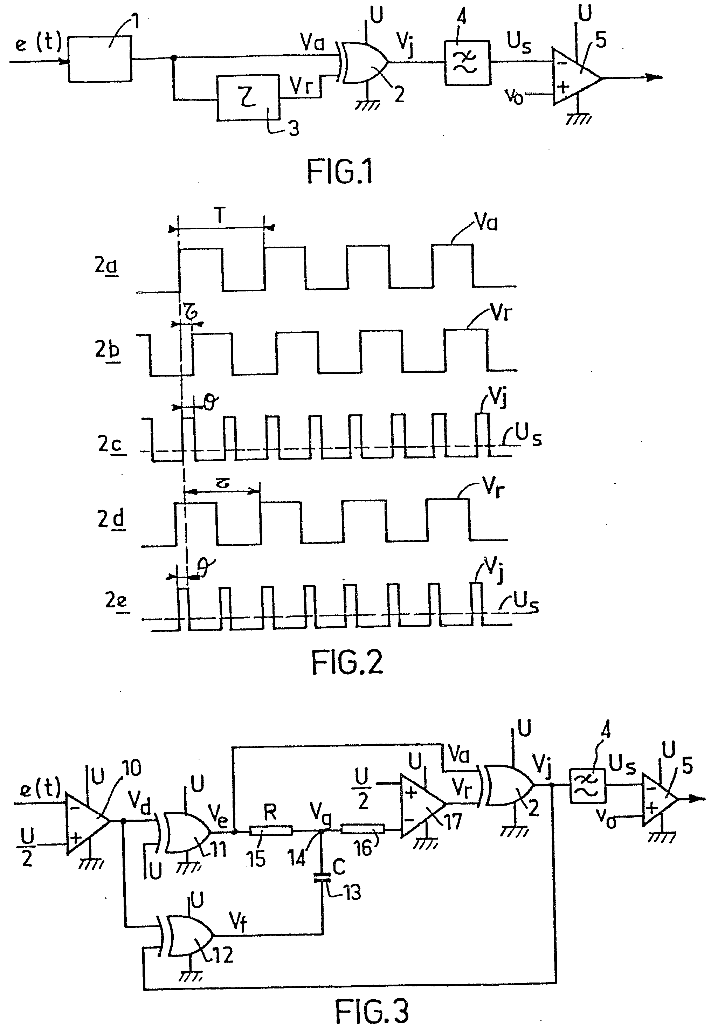

Sur la figure 1 est représenté le schéma de principe d'un démodulateur de fréquence du genre utilisé dans l'invention. A titre d'exemple, on suppose par la suite que ce démodulateur est utilisé pour la restitution de données transmises par modulation de la fréquence d'une porteuse. Le signal modulé en fréquence e(t) est appliqué à un circuit limiteur d'amplitude I qui fournit un signal rectangulaire d'amplitude U, ayant la fréquence F du signal modulé e(t). Le circuit »OU exclusif« 2, alimenté par la tension U d'une source d'alimentation, reçoit sur une entrée le signal rectangulaire $V_a$ fourni par le circuit limiteur 1 et sur son autre entrée le signal $V_r$ fourni par le circuit de retard 3 qui retarde d'une durée $\tau$ le signal $V_a$. Le signal non retardé $V_a$, de période

0 042 641

$$T = \frac{1}{F}$$

est montré sur le diagramme 2a de la figure 2. Le signal $V_r$ retardé de la durée $\tau$ est montré sur le diagramme 2b dans le cas où

$$0 < \tau < \frac{T}{2}.$$

A la sortie du circuit »OU exclusif« 2, on obtient comme le montre le diagramme 2c, le signal impulsionnel $V_j$ formé d'impulsions d'amplitude U et suivant les transitions du signal non retardé $V_a$. Ces impulsions ont la largeur $\theta = \tau$. Sur le diagramme 2d on a représenté le signal retardé $V_r$ dans le cas où

$$\frac{T}{2} < \tau < T,$$

et le diagramme 2e montre le signal impulsionnel $V_j$ qui en résulte à la sortie du circuit »OU exclusif« 2; dans ce cas les impulsions du signal $V_j$ précèdent les transitions du signal non retardé $V_a$ et leur largeur est $\theta = T - \tau$. Il est clair que dans tous les cas la durée $\theta$ des impulsions du signal $V_j$ est au minimum nulle et au maximum égale à $\frac{T}{2}$. Le signal impulsionnel $V_j$ fourni par le circuit »OU exclusif« 2 est appliqué au filtre passe-bas 4 qui en fournit la valeur moyenne. Cette valeur moyenne du signal $V_j$ constitue le signal de sortie $U_S$ du démodulateur, qui est représenté par les lignes horizontales en pointillé sur les diagrammes 2c et 2e. Il est facile de montrer que le signal $U_S$ a pour expression:

$$U_S = 2 U \cdot \theta \cdot F \tag{1}$$

Dans la plus part des démodulateurs de fréquence connus, le circuit de retard 3 produit un retard $\tau$ de durée fixe et ce retard est produit par exemple par un registre à décalage comme le décrit le brevet précité n° 2 237 357. On voit d'après la formule (1) que la tension de sortie $U_S$ du démodulateur est proportionnelle à la fréquence F du signal modulé en fréquence. Pour restituer des données transmises en affectant à une porteuse deux fréquences $F_A$ et $F_B$, on applique le signal $U_S$ à l'entrée inverseuse d'un amplificateur opérationnel 5 l'entrée non inverseuse reçoit la tension fixe $v_0$. Cet amplificateur 5 alimenté par la tension U fonctionne comme un circuit comparateur qui, en comparant la tension $U_S$ à la tension de seuil $v_0$, restitue les données correspondant aux fréquences $F_A$ et $F_B$.

Pour juger des performances de ce démodulateur, il est commode de définir la variation $\Delta U_S$ du signal de sortie pour un déplacement de fréquence de $F_A$ à $F_B$ du signal modulé. On a évidemment:

$$\Delta U_S = 2 U \theta (F_A - F_B) \tag{2}$$

D'autre part on peut définir la valeur moyenne $V_m$ du signal de sortie $U_S$, en supposant que les deux valeurs possibles de ce signal $U_S$ pour les fréquence $F_A$ et $F_B$ sont équiprobables; cette valeur moyenne $V_m$ s'écrit:

$$V_m = U \theta (F_A + F_B) \tag{3}$$

Il est bien entendu avantageux que la tension de seuil $v_0$ fournie au comparateur 5 soit égale à cette valeur moyenne $V_m$.

En faisant apparaître la fréquence centrale

$$F_0 = \frac{F_A + F_B}{2},$$

la variation $\Delta U_S$ du signal de sortie du démodulateur, rapportée à sa valeur moyenne $V_m$ peut s'écrire:

$$\frac{\Delta U_S}{V_m} = \frac{F_A - F_B}{F_0}.$$

Cette dernière formule met en évidence une caractéristique de ce démodulateur connu, à savoir que la valeur relative de sa tension de sortie

3

$$\frac{\Delta U_S}{V_m}$$

ne dépend que de l'écart relatif

$$\frac{F_A - F_B}{F_0},$$

ce qui est un inconvénient lorsque cet écart relatif

$$\frac{F_A - F_B}{F_0}$$

est assez faible. En transmission de données on utilise par exemple les valeurs de fréquence $F_A = 1850$ Hz, $F_B = 1650$ Hz. On trouve donc

$$\frac{\Delta U_S}{V_m} \simeq 11,4\%.$$

Avec $V_m = 6$ V on trouve $\Delta U_S \simeq 0,68$ V. Dans cet exemple, la tension $U_S$ prend donc en fonction des données, en régime établi, les deux valeurs $U_{SA} = 6,34$ V et $U_{SB} = 5,66$ V qui sont à comparer dans le comparateur 5 à la tension $v_o = V_m = 6$ V. On conçoit que des bruits et dérives affectant le signal $U_S$ ou engendrés dans le comparateur 5 puissent produire des distorsions biaises importantes dans les données restituées par ce comparateur.

La présente invention fournit un démodulateur de fréquence que l'on peut aisément adapter au domaine de fréquence du signal modulé pour obtenir des variations $\Delta U_S$ du signal de sortie beaucoup plus importantes que dans le démodulateur connu.

Dans le démodulateur de l'invention, le circuit de retard 3 est agencé pour produire un retard $\tau$ variable avec la fréquence F de façon qu'en valeur absolue la différence de phase entre les signaux rectangulaires $V_a$ et $V_r$ appliqués aux entrées du circuit »OU exclusif« 2 varie au maximum de 0 à 180" en sens inverse de la fréquence F.

On retrouve un tel circuit à retard variable avec la fréquence dans le démodulateur décrit dans le brevet américain précité n° 3 748 586. Mais dans ce démodulateur connu ce circuit à retard est réalisé de façon relativement compliquée et n'est pas facilement réglable.

Pour montrer clairement la différence entre un démodulateur à circuit de retard $\tau$ fixe et un démodulateur à circuit de retard $\tau$ variable, on peut exprimer la tension de sortie $U_S$ du démodulateur en fonction de la différence de phase $\varphi$ entre les deux signaux $V_a$ et $V_r$ appliqués aux deux entrées du circuit »OU exclusif« 2, cette différence de phase $\varphi$ étant toujours comptée de façon positive et limitée à 180°. La formule (1) peut s'écrire:

$$U_S = \frac{U}{\Pi} \varphi \quad \text{avec} \quad \varphi = 2\Pi\Theta F \tag{4}$$

Dans un modulateur de fréquence à retard $\tau$ fixe, la durée d'impulsions $\Theta$ est fixe; la différence de phase $\varphi$ et donc la tension de sortie $U_S$ du démodulateur sont proportionnelles à la fréquence F.

Par contre, dans le démodulateur de fréquence de l'invention, le retard $\tau$ et donc la durée d'impulsions $\Theta$ sont variables de façon que la différence de phase $\varphi$ et donc la tension de sortie $U_S$ varient en sens inverse de la fréquence F.

La variation $\Delta U_S$ du signal de sortie du démodulateur pour un déplacement de fréquence de $F_A$ à $F_B$ du signal modulé peut s'écrire:

$$\Delta U_S = 2U \, | \, (\Theta_A F_A - \Theta_B F_B) \, |, \tag{5}$$

$\Theta_A$ et $\Theta_B$ étant les durées d'impulsions du signal $V_j$ pour les fréquences $F_A$ et $F_B$.

La valeur moyenne $V_m$ du signal de sortie $U_S$ pour les fréquences $F_A$ et $F_B$ peut s'écrire:

$$V_m = U(\Theta_A F_A + \Theta_B F_B) \tag{6}$$

Ces deux formules (5) et (6) montrent clairement que pour deux fréquences données $F_A$ et $F_B$ la variation $\Delta U_S$ et la valeur moyenne $V_m$ du signal de sortie $U_S$ peuvent être réglées en agissant sur les largeurs d'impulsions $\Theta_A$ et $\Theta_B$, c'est-à-dire sur les valeurs du retard $\tau$ produit par le circuit de retard 3 pour les fréquences $F_A$ et $F_B$.

Pour mettre en oeuvre l'invention, on pourrait réaliser le retard $\tau$ variable requis au moyen d'un registre à décalage commandé par exemple par des impulsions de décalage de fréquence variable en

4

fonction de la fréquence F. Il est plus simple de réaliser ce retard $\tau$ variable par des moyens analogiques, du genre de ceux utilisés dans deux modes de réalisation de l'invention que l'on va maintenant décrire.

Un premier mode de réalisation du démodulateur de l'invention est représenté su la figure 3. Un certain nombre d'éléments des figures 1 et 3 sont identiques et sont référencés de la même manière. Tous les circuits actifs indiqués sont alimentés par une source d'alimentation unique non représentée, fournissant la tension U; la tension $\frac{U}{2}$ qui est appliquée comme on va le voir sur une entrée à forte impédance de circuits comparateurs peut être avantageusement obtenue par un diviseur de tension à résistance branché sur la source unique d'alimentation.

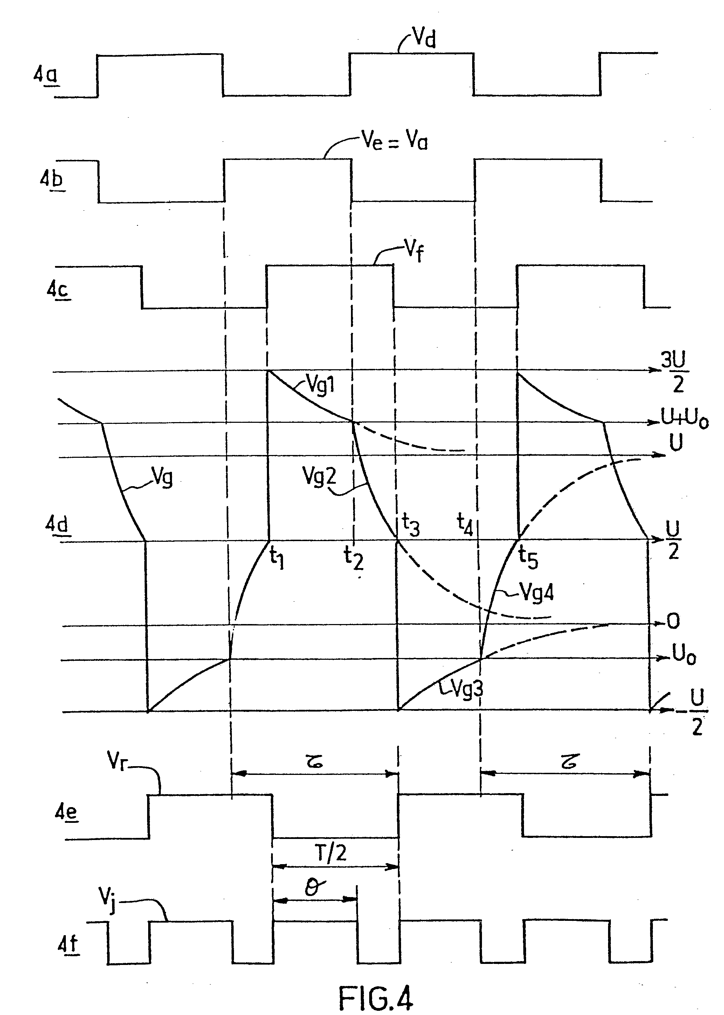

Le signal e(t) modulé en fréquence est appliqué à l'entrée inverseuse de l'amplificateur opérationnel 10 dont l'entrée non inverseuse reçoit la tension $\frac{U}{2}$. Cet amplificateur opérationnel forme un circuit limiteur d'amplitude qui fournit un signal rectangulaire $V_d$ d'amplitude U et de période T, qui est montré sur le diagramme 4a de la figure 4. Ce signal $V_d$ est appliqué à une entrée du circuit »OU exclusif« 11, dont l'autre entrée reçoit la tension U. Ce circuit 11 joue ainsi le rôle de circuit inverseur et le signal $V_e$ à sa sortie est représenté sur le diagramme 4b. Le signal $V_e$ constitue le signal non retardé $V_a$ qui est appliqué à une entrée du circuit »OU exclusif« 2. Le circuit »OU exclusif« 2 est suivi du filtre passe-bas 4 et du circuit comparateur 5 ayant les mêmes fonctions que sur la figure 2.

Pour fournir sur l'autre entrée du circuit »OU exclusif« 2, le signal $V_r$, retardé d'une durée $\tau$ variable, on utilise les élements suivants : le circuit »OU exclusif« 12 a une entrée qui est connectée à la sortie de l'amplificateur opérationnel 10 et son autre entrée qui est connectée à la sortie du circuit »OU exclusif« 2. La sortie du circuit 12 fournit le signal rectangulaire $V_f$ ayant la forme montrée sur le diagramme 4c et expliquée par la suite. La sortie du circuit 12 est connectée, via le condensateur 13 de capacité C à la borne 14 interconnectant les résistances en série 15 et 16. On appelle $V_g$ le signal sur cette borne 14 et ce signal a la forme indiquée sur le diagramme 4d et expliqué par la suite. Le montage en série des deux résistances 15 et 16 est connecté entre la sortie du circuit »OU exclusif« 11 et l'entrée inverseuse de l'amplificateur opérationnel 17. Ce dernier joue le rôle d'un circuit comparateur qui compare la tension variable appliquée sur son entrée inverseuse à la tension $\frac{U}{2}$ appliquée sur son entrée non inverseuse. Il fournit comme on l'expliquera par la suite le signal retardé $V_r$ qui est appliqué à une entrée du circuit »OU exclusif« 2. Le signal retardé $V_r$ est représenté sur le diagramme 4e. On déduit aisément des deux signaux $V_a$ et $V_r$ appliqués aux entrées du circuit 2 et représentés sur les diagrammes 4b et 4e, le signal de sortie $V_i$ de ce circuit 2, dont le filtre 4 forme la valeur moyenne $U_s$.

Le fonctionnement de l'ensemble des circuits permettant d'obtenir le signal impulsionnel $V_i$ va être expliqué maintenant au moyen des différents diagrammes de la figure 4.

On se place initialement à l'instant $t_1$ où le signal non retardé $V_a$ a la valeur U et le signal $V_g$ croissant atteint la tension $\frac{U}{2}$ qui fait basculer le comparateur 17. A cet instant $t_1$, le signal $V_r$ tombe donc de U à 0 et le signal $V_i$ monte de 0 à U. Comme le signal $V_d$ est alors égal à 0, il en résulte que le signal $V_f$ monte de 0 à U. Comme $V_f$ est appliqué à une borne du condensateur 13, le signal $V_g$ à l'autre borne de ce condensateur, monte ainsi brusquement à l'instant $t_1$ de

$$\frac{U}{2} \quad \text{à} \quad \frac{3U}{2}.$$

Après l'instant $t_1$ le signal $V_g$ décroît exponentiellement avec la constante de temps RC déterminée par le condensateur 13 de capacité C et la résistance 15 de valeur R. Cette loi de décroissance après l'instant $t_1$ est:

$$V_{g1} = \frac{U}{2} e^{-\frac{t-t_1}{RC}} + U \tag{7}$$

On vérifie que l'on a bien:

$$\text{pour } t = t_1 \quad V_{g1} = \frac{3U}{2}$$

$$t = \infty \quad V_{g1} = U$$

Le diagramme 4d montre la courbe $V_{g1}$ qui se compose d'une partie en trait plein prolongée par un trait en pointillé.

A l'instant $t_2$ où le signal $V_a$ tombe à 0, le signal $V_i$ tombe également à zéro et comme en même temps le signal $V_d$ monte à la tension U, le signal $V_f$ reste à la tension U. Mais le fait que le signal $V_e = V_a$ soit tombé à 0, entraîne qu'après l'instant $t_2$ la tension $V_g$ décroît exponentiellement suivant une autre loi que la loi $V_{g1}$ indiquée par la formule (7); après l'instant $t_2$, la loi de décroissance du signal $V_g$ est:

$$V_{g2} = (U + U_0)\, e^{-\frac{t-t_2}{RC}} \tag{8}$$

On vérifie que l'on a bien:

$$\text{pour } t = t_2 \quad V_{g2} = U + U_0$$

$$\text{pour } t = \infty \quad V_{g2} = 0$$

$U_o$ est une certaine tension comprise entre $0$ et $\dfrac{U}{2}$.

Le diagramme 4d montre la courbe $V_{b2}$, composée d'une partie en trait plein prolongée par un trait en pointillé.

A l'instant $t_3$ où le signal $V_g$ décroissant atteint la tension $\dfrac{U}{2}$ qui fait basculer le comparateur 17, le signal $V_r$ monte de 0 à U ainsi que le signal $V_j$. Il en résulte que le signal $V_f$ tombe de U à 0 et que la tension $V_g$ descend brusquement de

$$+\frac{U}{2} \text{ à } -\frac{U}{2}.$$

Après cet instant $t_3$ la tension $V_g$ croît exponentiellement suivant la loi:

$$V_{g3} = -\frac{U}{2}\, e^{-\frac{t-t_1}{RC}} \tag{9}$$

on a bien pour

$$t = t_3 \quad V_{g3} = -\frac{U}{2}$$

$$t = \infty \quad V_{g3} = 0$$

La courbe $V_{g3}$ est montrée sur le diagramme 4d; au sens de variation près, sa forme est la même que la courbe $V_{g1}$.

A l'instant $t_4$ où le signal $V_a$ monte de 0 à U, le signal $V_j$ tombe de U à 0. Comme le signal $V_d$ tombe également de U à 0, le signal $V_f$ reste à zéro. Comme le signal $V_e = V_a$ monte de 0 à U, le signal $V_f$ croît après l'instant $t_4$ suivant une autre loi que $V_{g3}$ et qui est:

$$V_{g4} = -(U_0 + U)\, e^{-\frac{t-t_4}{RC}} + U \tag{10}$$

on a bien pour

$$t = t_4 \quad V_{g4} = -U_0$$

$$t = \infty \quad V_{g4} = U$$

La courbe $V_{g4}$ est montrée sur le diagramme 4d; au sens de variation près, sa forme est la même que la courbe $V_{g2}$.

A l'instant $t_5$ où le signal $V_g$ atteint la tension $\dfrac{U}{2}$, le même fonctionnement qu'à l'instant $t_1$ se reproduit.

L'examen de la courbe du signal $V_g$, montre que ce signal est périodique avec la période T et est symétrique par rapport à la tension $\dfrac{U}{2}$. Ce signal $V_g$ permet d'engendrer à une entrée du circuit »OU exclusif« 2 le signal retardé $V_r$ montré en 4e, qui a un retard

$$\tau > \frac{T}{2}$$

sur le signal $V_a$ appliqué à l'autre entrée dudit circuit 2. Il en résulte des impulsions de durée $\theta$ dans le signal impulsionnel $V_j$ montré sur le diagramme 4f. Le circuit décrit produit un retard $\tau$ variable avec la fréquence $\dfrac{1}{T}$, c'est-à-dire puisque $\theta = T - \tau$, une durée d'impulsion $\theta$ variable avec la fréquence $\dfrac{1}{T}$.

La loi de variation de la largeur d'impulsions $\theta$ avec la fréquence

$$F = \frac{1}{T}$$

résulte de calculs simples dont on indique ci-après le principe. On voit d'après les diagrammes 4d et 4f que pendant la durée $\theta$, la courbe $V_{gl}$ par exemple, varie de

$$\frac{3U}{2} \text{ à } U + U_0.$$

On peut aisément déduire alors de la formule (7):

$$\theta = RC \, Log \frac{U}{2U_0} \tag{11}$$

D'autre part pendant l'intervalle

$$\frac{T}{2} - \theta$$

entre les impulsions du signal $V_j$, la courbe $V_{g2}$ par exemple varie de

$$U + U_0 \text{ à } \frac{U}{2}.$$

On peut en déduire:

$$\frac{T}{2} - \theta = RC \, Log \, 2 \, \frac{(U + U_0)}{U}$$

et donc:

$$U_0 = \frac{U}{e^{\frac{1}{2F \, RC}} - 1}. \tag{12}$$

En combinant les formules (11) et (12) on obtient finalement:

$$\theta = RC \, Log \, \frac{1}{2} \left[ e^{\frac{1}{2F \, RC}} - 1 \right] \tag{13}$$

Il est aisé de voir que lorsque la fréquence Ff augmente, la largeur d'impulsions $\theta$ diminue et inversement.

La différence de phase $\varphi$ entre les signaux $V_a$ et $V_r$ appliqués au circuit »OU exclusif« 2 a pour expression $\varphi = 2\Pi\theta F$ et peut donc s'écrire en utilisant la formule (13):

$$\varphi = 2\Pi F \, RC \, Log \, \frac{1}{2} \left[ e^{\frac{1}{2F \, RC}} - 1 \right] \tag{14}$$

On a pu vérifier que cette expression $\varphi$ d'après la formule (14) répond à une caractéristique de l'invention, à savoir que $\varphi$ diminue lorsque la fréquence augmente et inversement. On a pu vérifier de plus que la dérivée de $\varphi$ augmente quand la fréquence augmente.

D'après la formule (14), la tension de sortie $U_S$ du démodulateur s'écrit:

$$U_s = 2U \, F \, RC \, Log \, \frac{1}{2} \left[ e^{\frac{1}{2F \, RC}} - 1 \right] \tag{15}$$

Cette tension de sortie varie avec la fréquence F de la même manière que la différence de phase $\varphi$. Elle diminue quand la fréquence F augmente et la pente de la courbe de $U_S$ en fonction de F augmente quand la fréquence augmente. La formule (15) montre clairement que l'on peut régler la loi de variation de la tension de sortie $U_S$ avec la fréquence F, en réglant la constante de temps RC, c'est-à-dire pratiquement la valeur ohmique R de la résistance 15.

Dans le cas d'un démodulateur pour données transmises par deux fréquences $F_A$ et $F_B$, il peut être intéressant que pour la fréquence la plus élevée, soit par exemple $F_A$, le signal de sortie $U_S$ soit nul.

7

Cette condition est réalisée lorsque pour cette fréquence $F_A$ la largeur $\theta_A$ des impulsions du signal $V_j$ est nulle. On déduit alors aisément des formules (11) et (12) que l'on a alors:

$$RC = \frac{1}{2} \frac{1}{F_A \log 3}. \tag{16}$$

Cette formule (16) montre ainsi la valeur que l'on doit donner à la constante de temps RC pour obtenir une tension de $U_{SA}$ nulle pour la fréquence la plus élevée $F_A$. La variation $\Delta U_S$ du signal de sortie du démodulateur vaut alors évidemment d'après la formule (5) $\Delta U_S = 2 U \theta_B F_B$, où $\theta_B$ est donné par la formule (13) en y remplaçant RC par la valeur donnée par (16). Dans ce cas la variation $\Delta U_S$ a sa valeur maximale possible et la valeur moyenne $V_m$ entre les deux valeurs du signal de sortie $U_S$ pour les fréquences $F_A$ et $F_B$ est forcément égale à

$$\frac{\Delta U_S}{2}$$

puisque pour l'une de ces fréquences $F_A$ le signal de sortie est nul.

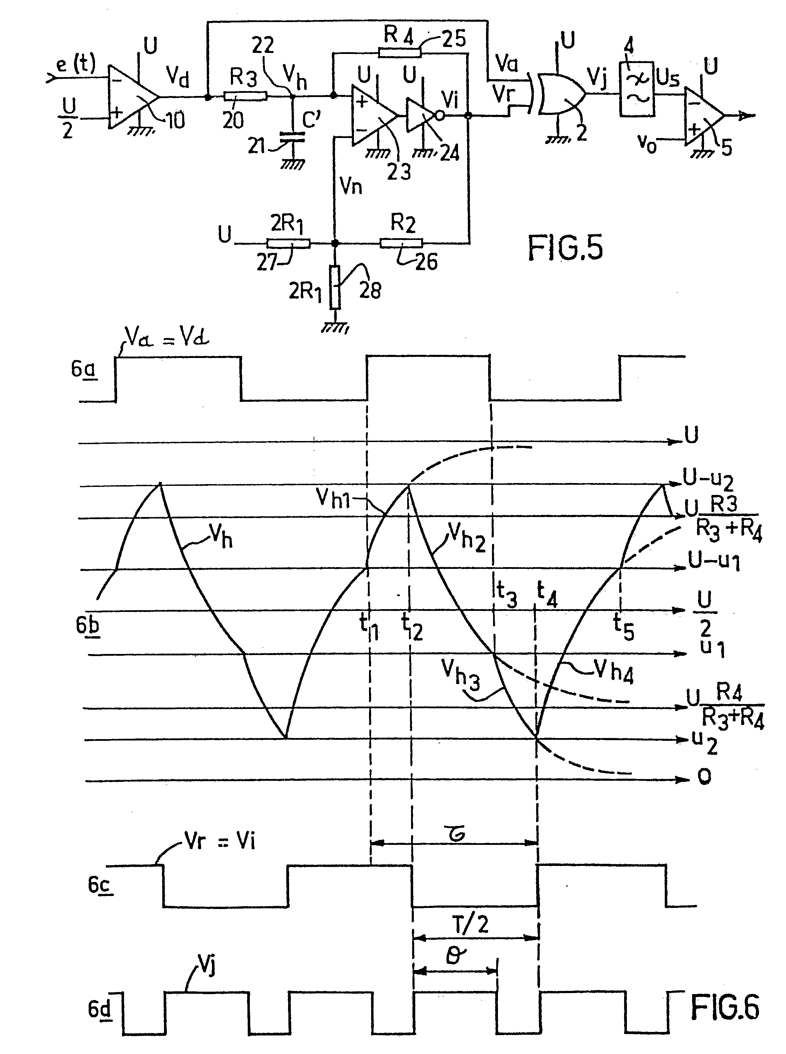

Un autre mode de réalisation du démodulateur de l'invention est représenté sur le schéma de la figure 5. Sur ce schéma, on retrouve un certain nombre d'éléments des figures 2 et 3, référencés de la même manière.

A la sortie du circuit limiteur d'amplitude formé par l'amplificateur opérationnel 10 apparaît le signal rectangulaire $V_d$ d'amplitude U, ayant la fréquence

$$F = \frac{1}{T}$$

du signal modulé en fréquence e(t). Ce signal $V_d$ représenté sur le diagramme 6a de la figure 6 constitue le signal non retardé $V_a$ qui est appliqué à une entrée du circuit »OU exclusif« 2.

Le signal $V_r$ appliqué à l'autre entrée du circuit 2 est obtenu en retardant le signal $V_d$ d'une durée $\tau$ variable avec la fréquence F, au moyen des circuits suivants:

Le signal $V_d$ est appliqué à un circuit intégrateur constitué par la résistance 20 de valeur $R_3$ en série avec le condensateur 21 de capacité C', qui est connecté à la masse reliée à la borne négative de la source d'alimentation. Sur la borne 22 commune à la résistance 20 et au condensateur 21, on obtient le signal $V_h$ dont la forme représentée sur le diagramme 6b sera expliquée par la suite. La borne 22 est reliée à l'entrée non inverseuse de l'amplificateur opérationnel 23 qui a la fonction d'un circuit comparateur comparant le signal $V_h$ appliqué sur son entrée non inverseuse au signal $V_n$ appliqué sur son entrée inverseuse. Le signal de sortie du circuit 23 est inversé à l'aide du circuit inverseur 24. Le signal de sortie $V_i$ de ce circuit 24 est appliqué d'une part à l'entrée non inverseuse de l'amplificateur opérationnel 23 à travers la résistance 25 de valeur $R_4$ et d'autre part à l'entrée inverseuse de l'amplificateur 23 à travers la résistance 26 de valeur $R_2$. Cette entrée inverseuse est également reliée à la borne commune de deux résistances en série 27 et 28 ayant la même valeur $2 R_1$ et connectées entrer la borne positive de la source d'alimentation ayant la tension U et la masse. Le signal $V_n$ sur l'entrée inverseuse de l'amplificateur opérationnel 23 peut prendre deux valeurs, selon que le signal $V_i$ vaut 0 ou U. On peut montrer aisément que ces deux valeurs sont:

$$\left.\begin{array}{ll} \text{Pour } V_i = 0 & V_n = u_2 \\[2mm] \text{Pour } V_i = U & V_n = U - u_2 \end{array}\right\} \tag{17}$$

avec

$$u_2 = \frac{U}{2} \frac{R_2}{R_2 + R_1}.$$

L'amplificateur opérationnel 23 compare le signal $V_h$ à ces deux valeurs possibles du signal $V_n$ et il en résulte le signal $V_i$ à la sortie du circuit inverseur 24. Ce signal $V_i$ représenté sur le diagramme 6c constitue le signal $V_r$ retardé appliqué à une entrée du circuit »OU exclusif« 2. On déduit aisément des signaux $V_a$ et $V_r$ représentés sur les diagrammes 6a et 6c, le signal $V_j$ apparaissant à la sortie du circuit »OU exclusif« 2 et qui est formé comme prédécemment d'impulsions d'amplitude U et de durée $\theta$ comme le montre le diagramme 6d.

On va maintenant expliquer comment est construit le signal $V_h$ présent sur l'entrée non inverseuse de l'amplificateur opérationnel 23 et qui est représenté sur le diagramme 6b.

On se place initialement à l'instant $t_1$ où le signal $V_d$ monte de 0 à U, le signal $V_i$ ayant alors la valeur U, ce qui d'après les relations (17) signifie que $V_n = U - u_2$. A cet instant $t_1$ le signal $V_h$ a une certaine valeur $U - u_1 < U - u_2$, $u_1$ étant une valeur que l'on définira par la suite. Après l'instant $t_1$, puisque les

tensions $V_i$ et $V_d$ ont la même valeur U, on peut dire que le condensateur 21 se charge au moyen de la tension U qui lui est appliquée à travers les résistances 20 et 25 en parallèle. Si l'on appelle R' la résistance équivalente à ces deux résistances 20 et 25 en parallèle, soit

$$R' = \frac{R_3 R_4}{R_3 + R_4},$$

on peut montrer aisément que la loi de variation de la tension $V_h$ après l'instant $t_1$ est:

$$V_{h1} = u_1 \left( 1 - e^{-\frac{t - t_1}{R'C'}} \right) + U - u_1. \tag{18}$$

On vérifie que l'on a:

$$\text{pour } t = t_1 \quad V_{h1} = U - u_1$$

$$t = \infty \quad V_{h1} = U$$

Le diagramme 4b montre la courbe $V_{hl}$ qui se compose d'une partie en trait plein prolongée par un trait en pointillé.

A l'instant $t_2$ où la tension $V_h$ croissante atteint la tension $V_n = U - u_2$ présente sur l'entrée inverseuse de l'amplificateur opérationnel 23, la tension $V_i = V_r$ tombe à zéro comme le montre le diagramme 6c. Comme cela résulte des relations (17), en même temps la tension $V_n$ tombe à $u_2$. Après l'instant $t_2$, le condensateur 21 se décharge par la borne intermédiaire d'un diviseur de tension formé par les résistances 25 et 20 en série, une extrémité de ce diviseur de tension étant à la tension U (résistance 20), l'autre extrémité étant à la masse (résistance 25). On peut montrer que la loi de variation de la tension $V_h$ après l'instant $t_2$ est:

$$V_{h2} = \left( U - u_2 - \frac{R_4}{R_3 + R_4} U \right) e^{-\frac{t - t_2}{R'C'}} + \frac{R_4}{R_3 + R_4} U. \tag{19}$$

On vérifie que l'on a:

$$\text{pour } t = t_2 \quad V_{h2} = U - u_2$$

$$t = \infty \quad V_{h2} = \frac{R_4}{R_3 + R_4} U$$

Le diagramme 6b montre la courbe $V_{h2}$ qui comprend une partie en trait plein prolongée par un trait en pointillé.

A l'instant $t_3$ où le signal $V_d$ tombe de U à O, le signal $V_h$ a une certaine valeur $u_1$. Après l'instant $t_3$, puisque les signaux $V_i$ et $V_d$ ont la même valeur O, le condensateur 21 se décharge par la tension O qui lui est appliquée à travers les deux résistances 20 et 25 en parallèle. On peut montrer que la loi de variation de la tension $V_h$ après l'instant $t_3$ est:

$$V_{h3} = u_1 e^{-\frac{t - t_3}{R'C'}} \tag{20}$$

On vérifie que l'on a:

$$\text{pour } t = t_3 \quad V_{h3} = u_1$$

$$t = \infty \quad V_{h3} = 0.$$

Le diagramme 4b montre la courbe $V_{h3}$ composée d'une partie en trait continu prolongée par un trait en pointillé.

A l'instant $t_4$ où le signal $V_h$ décroissant atteint la tension $V_n = u_2$ présente sur l'entrée inverseuse de l'amplificateur opérationnel 23, la tension $V_i = V_r$ monte de 0 à U comme le montre le diagramme 6c. Comme cela résulte des relations (17), en même temps la tension $V_n$ monte à $U - u_2$. Après l'instant $t_4$, le condensateur 21 se charge par la borne intermédiaire d'un diviseur de tension formé par les résistances 25 et 20 en série, une extrémité de ce diviseur de tension étant à la tension U (résistance 25), l'autre extrémité étant à la masse (résistance 20). On peut montrer que la loi de variation de la tension $V_h$ après l'instant $t_4$ est:

9

$$V_{h4} = \left( u_2 - \frac{R_3}{R_3 + R_4} U \right) e^{-\frac{t-t_4}{R'C'}} + \frac{R_3}{R_3 + R_4} U. \tag{21}$$

On vérifie que l'on a:

$$\text{pour } t = t_4 \quad V_{h4} = u_2$$

$$t = \infty \quad V_{h4} = \frac{R_3}{R_3 + R_4} U$$

Le diagramme 4b montre la courbe $V_{h4}$ composée d'une partie en trait continu prolongée par un trait pointillé.

A l'instant $t_5$ où le signal $V_d$ monte de 0 à U, le signal $V_h$ atteint une tension $U-u_1$, $u_1$ étant la tension de ce signal $V_h$ à l'instant $t_3$. Après l'instant $t_5$, le même fonctionnement qu'après l'instant $t_1$ se reproduit.

L'examen de la courbe du signal $V_h$ montre que ce signal est périodique avec la période T et est symétrique par rapport à la tension $\frac{U}{2}$. Ce signal $V_h$ permet d'obtenir à une entrée du circuit »OU exclusif« 2 le signal $V_r$ montré en 6c, qui est en retard de

$$\tau > \frac{T}{2}$$

sur le signal $V_a$ appliqué à l'autre entrée dudit circuit 2. Il en résulte des impulsions d'amplitude U et de durée $\theta$ dans le signal impulsionnel $V_j$ fourni par le circuit »OU exclusif« 2 et montré sur le diagramme 6d. Ce retard $\tau$ est variable avec la fréquence

$$F = \frac{1}{T},$$

et il en résulte que la durée d'impulsions $\theta = T - \tau$ du signal $V_j$ est également variable avec la fréquence F.

Pour déterminer la loi de variation de $\theta$ avec la fréquence F, on peut remarquer que pendant l'intervalle

$$\frac{T}{2} - \theta$$

entre les impulsions du signal $V_j$, la courbe $V_{h1}$ par exemple varie de $U-u_1$ à $U-u_2$ et que pendant la durée $\theta$, la courbe $V_{h2}$ par exemple varie de $U-u_2$ à $u_1$. En utilisant les formules (18) et (19) on peut montrer que $\theta$ a pour expression:

$$\theta = \frac{1}{2F} - R'C' \operatorname{Log} \frac{KU}{u_2 - (U - u_2 - KU) e^{-\frac{1}{2FR'C'}}} \tag{22}$$

avec

$$K = \frac{R_4}{R_3 + R_4}.$$

Avec cette expression de $\theta$ on a pu vérifier que la différence de phase $\varphi = 2\,\varPi\theta F$, entre les deux signaux $V_a$ et $V_f$ appliqués aux entrées du circuit »OU exclusif« 2, diminue quand la fréquence augmente et inversement.

La tension de sortie $U_S$ du démodulateur qui a pour expression

$$U_S = 2\,UF\,\theta = \frac{U}{\pi}\,\varphi,$$

varie avec la fréquence F de la même manière que la différence de phase $\varphi$. Il est clair que l'on peut réler comme on le désire la loi de variation de $\theta$ et donc la loi de variation de la tension de sortie $U_S$ avec la fréquence, en agissant sur différents paramètres apparaissant dans la formule (22), tels que C', R' K et $u_2$; les paramètres R' et K dépendent des valeurs $R_3$ et $R_4$ des résistances 20 et 25; la tension $u_2$ dépend notamment de la valeur $R_2$ de la résistance 26 et de la valeur $2\,R_1$ des résistances 27 et 28. On peut alors obtenir les valeurs que l'on désire pour la variation $\Delta U_S$ du signal de sortie du démodulateur pour deux fréquences $F_A$ et $F_B$ et pour la valeur moyenne $V_m$ de ce signal.

Un réglage particulier qui peut être avantageux dans certaines applications telles qu'une discrimination entre deux fréquences $F_A$ et $F_B$, consiste à donner aux différents éléments du démodulateur des valeurs telles que pour la fréquence la plus élevée $F_A$ la tension de sortie $U_S$ soit pratiquement nulle et pour la fréquence la plus basse $F_B$ la tension de sortie soit pratiquement égale à la tension d'alimentation U. Ceci signifie que la durée d'impulsion $\theta_A$ pour la fréquence $F_A$ doit être nulle et que la durée d'impulsion $\theta_B$ pour la fréquence $F_B$ doit être égale à $\frac{1}{2F_B}$. On se trouve alors dans les conditions les plus favorables pour la discrimination entre les deux fréquences $F_A$ et $F_B$, puisque la variation $\Delta U_S$ du signal de sortie pour ces deux fréquences $F_A$ et $F_B$ est pratiquement égale à la tension d'alimentation U, tandis que la valeur moyenne $V_m$ entre les deux valeurs du signal de sortie est d'après la formule (6) égale à $\frac{U}{2}$ .

Pour ce réglage particulier, on donne ci-après les relations à respecter entre les valeurs des différents éléments du démodulateur. En utilisant la formule (22), les conditions

$$\theta_A = 0 \text{ et } \theta_B = \frac{1}{2F_B}$$

peuvent s'écrire respectivement:

$$R'C' \text{ Log } \frac{KU}{u_2 - (U - u_2 - KU)\, e^{-\frac{1}{2F_A R'C'}}} = \frac{1}{2F_A} \qquad (23)$$

$$R'C' \text{ Log } \frac{KU}{u_2 - (U - u_2 - KU)\, e^{-\frac{1}{2F_B R'C'}}} = 0 \qquad (24)$$

La relation (24) s'écrit aussi:

$$KU = u_2 - (U - u_2 - KU)\, e^{-\frac{1}{2F_B R'C'}} \qquad (25)$$

Pour $u_2 = KU$, la relation (25) est sensiblement respectée si $F_B$ est suffisamment petit vis à vis de $\frac{1}{2R'C'}$ . On a donc sensiblement

$$\theta_B = \frac{1}{2F_B} \text{ et}$$

$U_S = 0$ si $u_2 = KU$ ou, compte tenu des valeurs de $u_2$ et K données plus haut, si:

$$\frac{1}{2}\,\frac{R_2}{R_1 + R_2} = \frac{R_4}{R_3 + R_4} . \qquad (26)$$

En se plaçant dans le cas où $u_2 = KU$, c'est-à-dire si la relation (26) est respectée, on peut montrer que la formule (23) qui est la condition pour que $\theta = 0$ et $U_S = U$, peut s'écrire:

$$R_3\, e^{-\frac{1}{2F_A C'R_3}} = R_4\, e^{-\frac{1}{2F_A C'R_4}} \qquad (27)$$

En conclusion, la quantité $\frac{1}{2R'C'}$ , étant choisie grande par rapport à la fréquence $F_B$ la plus faible, les deux formules (26) et (27) donnent le moyen de déterminer les valeurs des différents éléments du démodulateur pour obtenir sensiblement

$$\Delta U_S = U \text{ et } V_m = \frac{U}{2} .$$

Dans les modes de réalisation analogiques du démodulateur de fréquence, tels que ceux que l'on vient de décrire, il est avantageux que tous les circuits utilisés, d'une part soient alimentés par une source unique d'alimentation et d'autre part soient réalisés en technologie CMOS, du fait notamment que la résistance de sortie des circuits réalisés dans cette technologie CMOS est faible. Ces deux mesures favorisent la stabilité des caractéristiques du démodulateur en fonction des variations de la températur ambiante et des variations de la source d'alimentation.

## Revendications

1. Démodulator de fréquence comprenant un circuit-porte (2) ayant la fonction de »OU Exclusif« et recevant sur ses deux entrées des signaux rectangulaires ($V_a$, $V_r$) ayant la fréquence (F) du signal modulé en fréquence, des moyens de retard (3) pour retarder l'un desdits signaux rectangulaires ($V_r$) par rapport à l'autre ($V_a$), enfin un filtre passe-bas (4) connecté à la sortie du circuit-porte (2), lesdits moyens de retard (3) produisant un retard ($\tau$) variable avec la fréquence (F) de façon qu'en valeur absolue, la différence de phase ($\varphi$) entre lesdits signaux rectangulaires ($V_a$, $V_r$) varie au maximum de 0 à 180° en sens inverse de leur fréquence, caractérise en ce que lesdits moyens de retard (3) compor- tent un circuit intégrateur (15, 13 ou 20, 21) recevant le signal non retardé ($V_a$), un circuit comparateur (17 ou 23) pour comparer à un signal de seuil le signal ($V_g$ ou $V_h$) fourni par le circuit intégrateur, le signal retardé ($V_r$) étant obtenu à partir de la sortie du circuit comparateur (17 ou 23).

2. Démodulateur de fréquence selon la revendication 1, caractérisé en ce que ledit signal ($V_g$) fourni par le circuit intégrateur (15, 13) est obtenu sur une borne (14) du condensateur (13) dudit circuit intégrateur, l'autre borne de ce condensateur (13) recevant un signal ($V_f$) obtenu à partir du signal non retardé ($V_a$) et du signal de sortie ($V_j$) dudit circuit-porte (2) à fonction de circuit »OU Exclusif«, ledit signal de seuil étant un signal à un niveau $\left(\dfrac{U}{2}\right)$, le signal retardé ($V_r$) étant constitué par le signal de sortie du circuit comparateur (17).

3. Démodulateur de fréquence selon la revendication 2, caractérisé en ce que ledit signal ($V_f$) est formé à la sortie d'un autre circuit-porte (12) à fonction de »OU Exclusif«, qui reçoit sur une entrée le signal de sortie ($V_j$) dudit circuit-porte (2) et sur son autre entrée un signal ($V_d$) complémentaire du signal non retardé ($V_a$).

4. Démodulateur de fréquence selon la revendication 1, caractérisé en ce que ledit signal ($V_h$) fourni par le circuit intégrateur (20, 21) est obtenu sur une borne (22) du condensateur (21) dudit circuit intégrateur, cette borne (22) recevant le signal retardé ($V_r$) à travers une résistance (25) et le signal non retardé à travers la résistance (20) du circuit intégrateur tandis que l'autre borne du condensateur (21) est portée à un potentiel fixe, ledit signal de seuil étant un signal ($V_n$) à deux niveaux formé par un diviseur de tension (26), (27), (28) recevant le signal retardé ($V_r$), ce signal retardé étant constitué par le signal de sortie inversé du circuit comparateur (23).

5. Démodulateur de fréquence selon la revendication 4, caractérisé en ce que les composants (20), (25), (26), (27), (28) des circuits servant à former le signal retardé ($V_r$) sont réglés pour que la différence de phase entre lesdits signaux réctangulaires retardé ($V_r$) et non retardé ($V_a$) soit sensiblement nulle pour la fréquence la plus élevée et sensiblement égale à 180° pour la fréquence la plus faible.

## Patentansprüche

1. Frequenzmodulator mit einer ersten als Exklusiv-ODER-fungierenden Torschaltung (2), die an den zwei Eingängen Rechtecksignale ($V_a$, $V_r$) mit der Frequenz (F) des frequenzmodulierten Signals empfängt, mit Verzögerungsmitteln (3) zum Verzögern eines der genannten Rechtecksignale ($V_r$) gegen- über dem andern ($V_a$) und einem Tiefpaßfilter (4), das mit dem Ausgang der ersten Torschaltung (2) verbunden ist, wobei die genannten Verzögerungsmittel (3) eine sich mit der Frequenz (F) derart ändernde Verzögerung ($\tau$) herbeiführen, daß der Absolutwert des Phasenunterschieds ($\varphi$) zwischen den genannten Rechtecksignalen ($V_a$, $V_r$) im gegensinnig zu ihrer Frequenz maximal von 0 bis 180° variert, dadurch gekennzeichnet, daß die Verzögerungsmittel (3) eine Integratorschaltung (15, 13 oder 20, 21), die das unverzögerte Signal ($V_a$) empfängt, enthalten und eine Vergleichsschaltung (17 oder 23), die das von der Integratorschaltung gelieferte Signal ($V_g$ oder $V_h$) mit einem Schwellensignal vergleicht, wobei das verzögerte Signal ($V_r$) von dem Ausgang der Vergleichsschaltung (17 oder 23) erhalten wird.

2. Frequenzmodulator nach Anspruch 1, dadurch gekennzeichnet, daß das von der Integratorschaltung (15, 13) gelieferte an einer Klemme (14) des Kondensators (13) der Integratorschaltung erhalten wird, daß die andere Klemme des Kondensators ein Signal ($V_f$) empfängt, das aus dem nicht-verzöger- ten Signal ($V_a$) und aus dem Ausgangssignal ($V_j$) der ersten als Exklusiv-ODER fungierenden Torschaltung (2) abgeleitet wird, und daß das Schwellensignal ein Ein-Pegelsignal $\left(\dfrac{U}{2}\right)$ ist, während das verzö- gerte Signal ($V_r$) durch das Ausgangssignal der Vergleichsschaltung (17) gebildet wird.

3. Frequenzmodulator nach Anspruch 2, dadurch gekennzeichnet, daß das genannte Signal ($V_f$) an dem Ausgang einer zweiten als Exklusiv-ODER fungierenden Torschaltung (12) gebildet wird, die an einem Eingang das Ausgangssignal ($V_j$) der ersten Torschaltung (2) empfängt und an dem anderen Eingang ein Signal ($V_d$), das zu dem unverzögerten Signal ($V_a$) komplementär ist.

4. Frequenzmodulator nach Anspruch 1, dadurch gekennzeichnet, daß das vor der Integratorschaltung (20, 21) gelieferte Signal (V$_h$) an einer Klemme (22) des Kondensators (21) der Integratorschaltung erhalten wird, daß diese Klemme (22) das verzögerte Signal (V$_r$) über einen Widerstand (25) empfängt und das unverzögerte Signal über den Widerstand (20) der Integratorschaltung, während die andere Klemme des Kondensators (21) ein festes Potential hat, daß das Schwellensignal ein Signal (V$_n$) mit zwei Pegeln ist, das mittels eines Spannungsteilers (26), (27), (28), der das verzögerte Signal (V$_r$) empfängt, gebildet wird und daß das verzögerte Signal durch das invertierte Ausgangssignal der Vergleichsschaltung (23) gebildet wird.

5. Frequenzmodulator nach Anspruch 4, dadurch gekennzeichnet, daß die Elemente (20), (25), (26), (27), (28) der Schaltungsanordnungen zum Bilden des verzögerten Signals (V$_r$) geregelt werden, damit der Phasenunterschied zwischen den verzögerten (V$_r$) und nicht-verzögerten (V$_a$) Rechtecksignalen für die höchste Frequenz nahezu Null und für die niedrigste Frequenz nahezu gleich 180° ist.

## Claims

1. A frequency demodulator comprising a gate circuit (2) having an »exclusive-OR« function and receiving at its two inputs rectangular signals (V$_a$, V$_r$) having the frequence (F) of the frequency-modulated signal, delay means (3) for delaying one of said rectangular signals (V$_r$) relative to the other (V$_a$), and a low-pass filter (4) connected to the output of the gate circuit (2), said delay means (3) producing a delay ($\tau$) varying with frequency (F) in such a way that the absolute value of the phase difference ($\varphi$) between the rectangular signals (V$_a$, V$_r$) varies at most from 0° to 180° in the inverse sense to their frequency, characterized in that said delay means (3) comprise an integrating circuit (15, 13 or 20, 21) receiving the non-delayed signal (V$_a$), and a comparator circuit (17 or 23) for comparing the signal (V$_g$ or V$_h$) produced by the integrating circuit with a threshold signal, the delayed signal (V$_r$) being obtained from the output of the comparator circuit (17 or 23).

2. A frequency demodulator as claimed in Claim 1, characterized in that said signal (V$_g$) produced by the intergrating circuit (15, 13) is obtained at a terminal (14) of the capacitor (13) of said integrating circuit, the other terminal of this capacitor (13) receiving a signal (V$_f$) obtained from the non-delayed signal (V$_a$) and from the output signal (V$_j$) of said gate circuit (2) having an »exclusive-OR« function, said threshold signal being a single-level signal$\left(\dfrac{U}{2}\right)$, the delayed signal (V$_r$) being constituted by the output signal of the comparator circuit (17).

3. A frequency demodulator as claimed in Claim 2, characterized in that said signal (V$_f$) is formed at the output of a further gate circuit (12) having an »exclusive-OR« function, which gate circuit at one input receives the output signal (V$_j$) of said gate curcuit (2) and at its other input a signal (V$_d$) complementary to the non-delayed signal (V$_a$).

4. A frequency demodulator as claimed in Claim 1, characterized in that said signal (V$_h$) produced by the integrating circuit (20, 21) is obtained at a terminal (22) of the capacitor (21) of said integrating circuit, this terminal (22) receiving the delayed signal (V$_r$) via a resistor (25) and the non-delayed signal via the resistor (20) of the integrating circuit, while the other terminal of the capacitor (21) is connected to a fixed potential, said threshold signal being a two-level signal (V$_n$) formed by a voltage divider (26), (27), (28) receiving he delayed signal (V$_r$), this delayed signal being constituted by the inverted output signal of the comparator circuit (23).

5. A frequency demodulator as claimed in Claim 4, characterized in that the components (20), (25), (26), (27), (28) of the circuits serving to form the delayed signal (V$_r$) are adjusted in a way such that the phase difference between said delayed and non-delayed rectangular signals (V$_r$ and V$_a$) is substantially zero for the highest frequency and substantially equal to 180° for the lowest frequency.

FIG.1

FIG.2

FIG.3

FIG.4

FIG.5

FIG.6